Europäisches Patentamt

European Patent Office

Office européen des brevets

(11) Numéro de publication : **0 130 873**
**B1**

(12)   ` **FASCICULE DE BREVET EUROPÉEN**

(45) Date de publication du fascicule du brevet :
19.08.87

(51) Int. Cl.⁴ : **H 03 H 19/00**

(21) Numéro de dépôt : **84401220.3**

(22) Date de dépôt : **14.06.84**

(54) Filtre passe-bande à capacités commutées.

(30) Priorité : **24.06.83 FR 8310500**

(43) Date de publication de la demande :
**09.01.85 Bulletin 85/02**

(45) Mention de la délivrance du brevet :
**19.08.87 Bulletin 87/34**

(84) Etats contractants désignés :
**DE FR GB IT NL**

(56) Documents cités :
**NACHRICHTENTECHNIK-ELEKTRONIK, vol. 32, no. 2, 1982, Berlin (DD), B. MOSSNER: "Entwurf von switched-capacitor-Bandpässen bei tiefen Frequenzen", pages 77-80**
**IEEE 1983 INTERNATIONAL SYMPOSIUM ON CIRCUITS AND SYSTEMS, 2-4 mai 1983 à Newport Beach, California (US), vol. 2, IEEE, New York (US); R.B. DATAR et al.: "Exact design of strays-insensitive switched-capacitor ladder filters", pages 590-593**
**ELECTRONICS LETTERS, vol. 18, no. 25, 9 décembre 1982, Londres (GB), M. TAWFIK et al.: "Exact design of switched-capacitor bandpass ladder filters", pages 1101-1103**

(73) Titulaire : **THOMSON SEMICONDUCTEURS**
**101, bld Murat**
**F-75016 - Paris (FR)**

(72) Inventeur : **Caiion, Christian**
**THOMSON-CSF SCPI 173, bld Haussmann**
**F-75379 Paris Cedex 08 (FR)**
Inventeur : **Fensch, Thierry**
**THOMSON-CSF SCPI 173, bld Haussmann**
**F-75379 Paris Cedex 08 (FR)**

(74) Mandataire : **Guérin, Michel et al**
**THOMSON-CSF SCPI 19, avenue de Messine**
**F-75008 Paris (FR)**

**Description**

La présente invention concerne les filtres à capacités commutées.

On sait actuellement bien réaliser des filtres à capacités commutées (et notamment des filtres passe-bas) qui sont essentiellement la transposition de filtres à inductances et capacités. On peut par exemple lire à ce sujet l'article de Josef Nossek et Gabor Temes dans IEEE Transactions on circuits and systems, vol CAS-27 n° 6, juin 1980.

Le comportement d'un filtre à inductances et capacités est bien connu, et présente des propriétés intéressantes, notamment du point de vue de la stabilité du filtre et de sa faible sensibilité aux variations de valeur des composants qui le forment.

Ce comportement peut s'écrire sous forme d'une équation matricielle dans laquelle les inconnues sont les variables d'état du filtre (courants dans les inductances et tensions aux bornes des capacités), cette équation faisant intervenir la variable de Laplace s.

On peut remplacer, pour simuler le filtre LC par un filtre à capacités commutées, la variable s par la variable z des systèmes échantillonnés, ceci en utilisant des transformations connues (transformation bilinéaire ou transformation LDI par exemple).

La transformation bilinéaire présente un avantage important sur la transformation LDI (Lossless Discrete Integration) du fait que, contrairement à cette dernière, le filtre à capacités commutées obtenu simule exactement le prototype LC et en particulier permet de conserver des résistances de terminaison réelles et non complexes, ce qui est indispensable si on veut obtenir une réponse fréquentielle non déformée lorsqu'on s'approche de la fréquence d'échantillonnage. On s'intéresse donc ici uniquement à la transformation bilinéaire.

Par cette transformation, on aboutit à une nouvelle équation matricielle, en z, dont les inconnues représenteront par hypothèse les tensions de sorties d'amplificateurs opérationnels et dont les coefficients représenteront des liaisons de fonction de transfert en z bien déterminées entre les entrées et les sorties de ces amplificateurs : c'est là le principe de base de la synthèse d'un filtre à capacités commutées simulant un filtre LC.

Plus précisément, on s'arrange pour que l'équation matricielle établie comporte des coefficients en $z^{-1}$, $-z^{-1}$, $(1-z^{-1})$, k, où k est une constante et l'établissement du schéma du filtre à capacités commutées consiste à relier à l'entrée d'un amplificateur opérationnel, correspondant à une ligne respective donnée de l'équation matricielle, les sorties des divers amplificateurs par l'intermédiaire de blocs de liaison ayant pour fonctions de transfert les coefficients de cette ligne de l'équation matricielle. On expliquera mieux ce point sur un exemple précis dans la suite de la description.

Les fonctions de transfert $z^{-1}$, $-z^{-1}$, $(1-z^{-1})$ et k (k positif) peuvent être réalisées par des capacités commutées ou non commutées de types divers qu'on décrira par la suite.

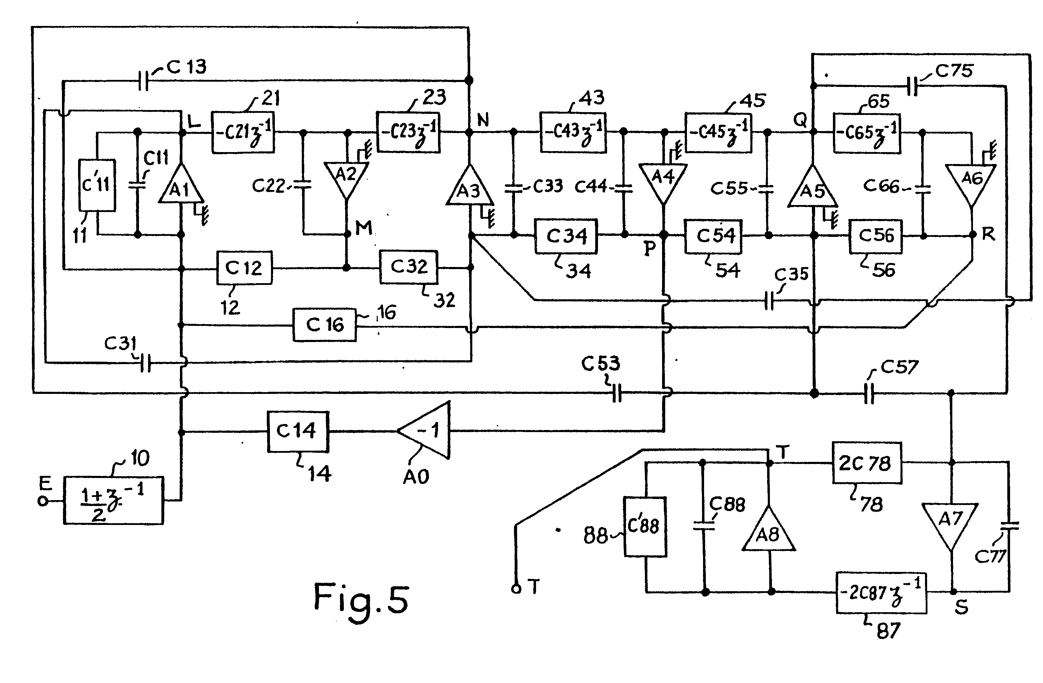

Le compte rendu de IEEE 1983 International Symposium on Circuits and Systems, article de R. B. Datar et A.S. Sedra, page 593 montre à sa figure 4 un filtre passe-bas conçu selon cette méthode.

Malheureusement, dans l'établissement d'une équation matricielle en z à partir du schéma d'un filtre passe-bande à inductances et capacités, il apparaît certains coefficients qui sont des constantes k négatives que l'on ne sait pas réaliser directement par une capacité commutée ou non commutée ; il est alors nécessaire de prévoir une capacité commutée correspondant à une constante positive $(-k)$ suivie ou précédée d'un inverseur, donc d'un amplificateur opérationnel supplémentaire, ce que l'on souhaite éviter pour des raisons de coût et d'encombrement de la surface sur laquelle est réalisé le filtre (notamment en circuits intégrés).

Pour cela, la présente invention propose de modifier l'équation matricielle par multiplication d'une ligne par un coefficient et addition de cette ligne à une autre, l'une des deux lignes étant celle qui contient un coefficient k négatif donc non réalisable et l'autre contenant, à la même position en colonne un coefficient positif et aux autres positions en colonne des coefficients tous directement réalisables par des capacités commutées ou non commutées.

On aboutit ainsi à un filtre qui comprend un nombre d'amplificateurs qui n'est pas supérieur à l'ordre du filtre à inductances et capacités que l'on désire simuler.

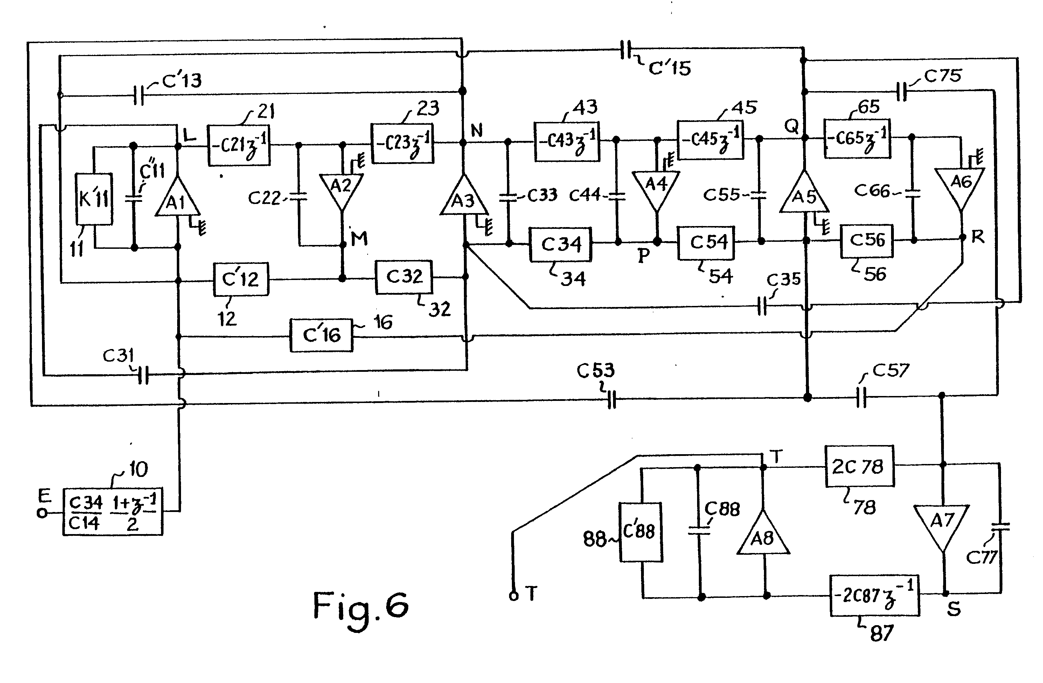

Ce filtre présente matériellement les particularités de liaison suivantes (les références numériques se rapportent à la figure 6) :

une capacité non commutée (C"11) en parallèle avec une capacité commutée (11) entre la sortie et l'entrée du premier amplificateur opérationnel (A1) ainsi que du dernier (C88, 88 pour l'amplificateur A8), et une capacité non commutée respective (C22, C33 ... C77) en parallèle entre la sortie et l'entrée de chacun des amplificateurs intermédiaires (A2 à A7) ;

une capacité commutée (12) sans retard (fonction de transfert k) entre l'entrée du premier et la sortie du second amplificateur, une autre (32) entre l'entrée du troisième et la sortie du second, et encore une autre (34) entre l'entrée du troisième et la sortie du quatrième ;

une capacité commutée inverseuse (21) avec retard (fonction de transfert $-z^{-1}$) entre l'entrée du deuxième amplificateur et la sortie du premier, et une autre (23) entre cette même entrée et la sortie du troisième amplificateur ;

une capacité non commutée (fonction de transfert $(1-z^{-1})$ entre l'entrée du premier amplificateur et la sortie du troisième (C'13), une autre (C'15) entre cette même entrée et la sortie du cinquième, une autre (C31) entre l'entrée du troisième et la sortie du premier amplificateur, et enfin une autre (C35) entre cette même entrée et la sortie du cinquième amplificateur.

En principe aucune liaison n'est prévue entre l'entrée du premier et la sortie du quatrième amplificateur.

D'autres caractéristiques et avantages de l'invention apparaîtront à la lecture de la description détaillée qui suit et qui est faite en référence aux dessins annexés dans lesquels :

la figure 1 représente un schéma de filtre passe-bande à inductances et capacités du huitième ordre ;

la figure 2 est une équation matricielle en s (variable de Laplace) représentant le comportement électrique de ce filtre ;

la figure 3 est une équation matricielle en z (variable des systèmes échantillonnés) résultant de l'application de la transformation bilinéaire à l'équation en s de la figure 2 ;

la figure 4 représente divers types de capacités commutées ou non ;

la figure 5 représente un filtre à capacités commutées synthétisé directement à partir de l'équation de la figure 3,

la figure 6 représente le filtre synthétisé selon l'invention.

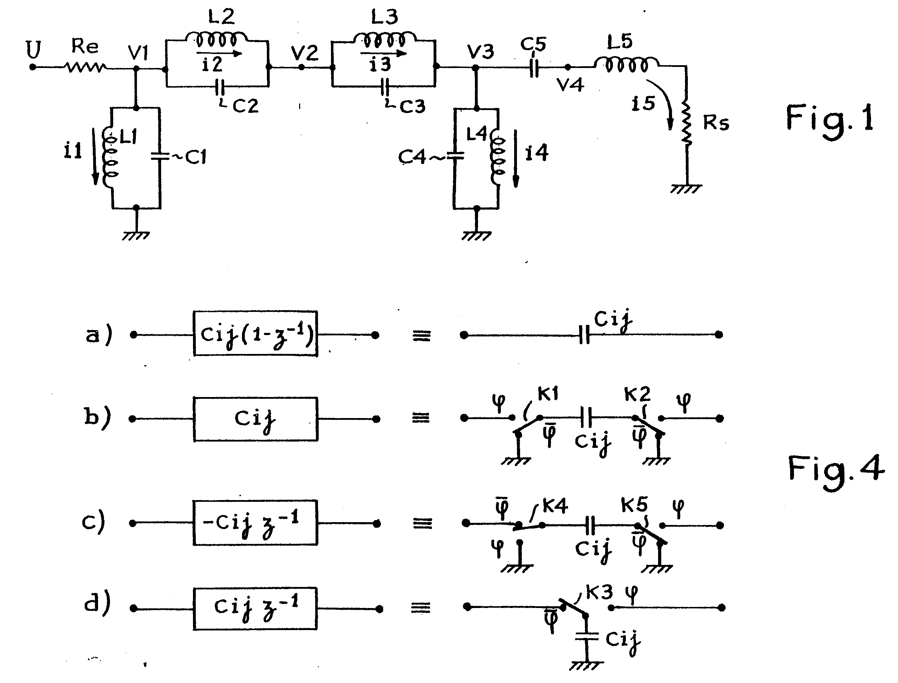

Un exemple de filtre passe-bande à inductances et capacités est représenté à la figure 1.

Il comporte une entrée à laquelle on applique une tension d'entrée U ; une résistance d'entrée en série Re ; un premier noeud sur lequel apparaît une tension V1 ; un premier circuit bouchon L1, C1 entre le premier noeud et la masse ; un deuxième circuit bouchon L2, C2 entre le premier noeud et un deuxième noeud sur lequel apparaît une tension V2 ; le courant dans l'inductance L2 du deuxième circuit bouchon est i2 ; un troisième circuit bouchon L3, C3 (courant i3 dans l'inductance L3) entre le deuxième noeud et un troisième noeud sur lequel apparaît une tension V3 ; un quatrième circuit bouchon L4, C4 (courant i4 dans l'inductance L4) entre le troisième noeud et la masse ; une capacité C5 entre le troisième noeud et un quatrième noeud sur lequel apparaît une tension V4 ; une inductance L5 en série avec une résistance de charge Rs entre le quatrième noeud et la masse ; le courant dans la charge Rs est i5 et c'est ce courant qui constitue le signal de sortie du filtre, la fonction de transfert i5/U étant une fonction passe-bande du huitième ordre.

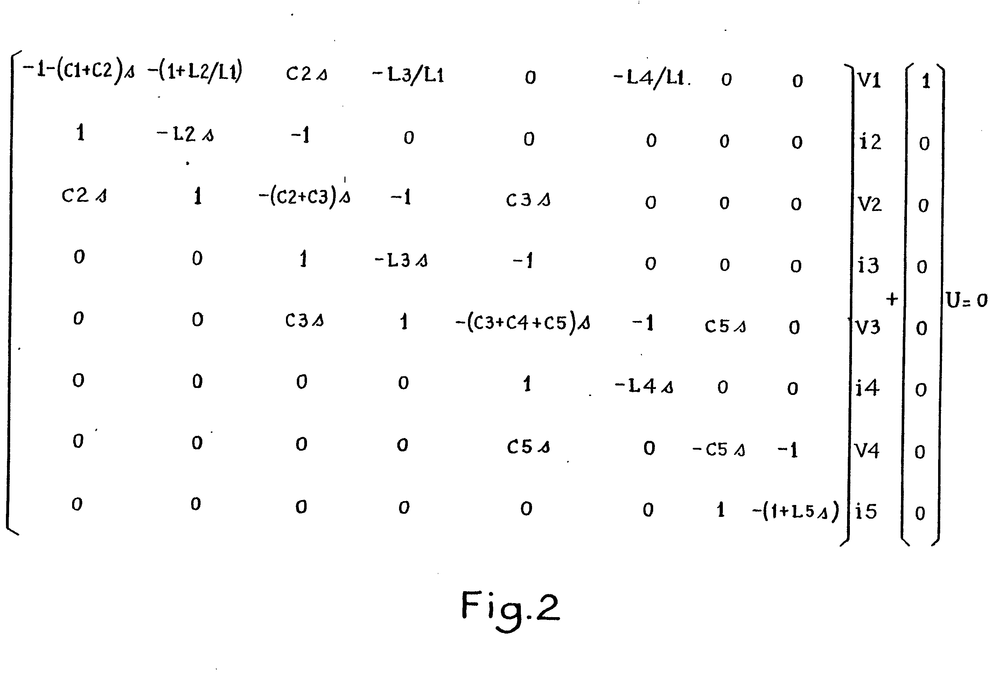

Le comportement de ce filtre peut s'exprimer sous la forme matricielle de la figure 2 où V1, i2, V2, i3, V3, i4, V4, i5 représentent les huit tensions et courants définis ci-dessus et constituent huit inconnues ; les résistances d'entrée et de charge Re et Rs sont supposées unitaires ; c'est la variable de Laplace.

L'équation matricielle peut être modifiée ensuite en remplaçant la variable s par $2(1 - z^{-1})/T$ $(1 + z^{-1})$ où T est la période d'échantillonnage du filtre à capacités commutées qui doit simuler le filtre analogique de la figure 1. Ce changement de variable constitue ce qu'on appelle la transformation bilinéaire.

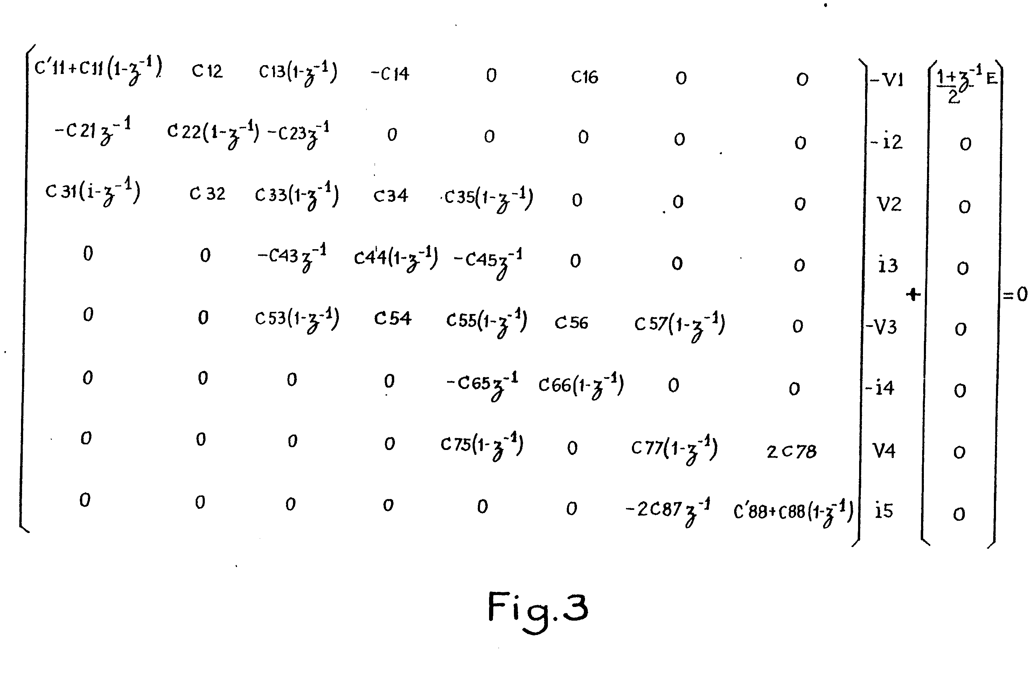

Par multiplication des différentes lignes de la matrice par $1 + z^{-1}$ ou $-(1 + z^{-1})$, on aboutit à l'équation matricielle en z de la figure 3 où on a, pour simplifier, introduit des coefficients Cij et C'ij (i indice de ligne, j indice de colonne) dont les valeurs sont fonction des valeurs de capacités et inductances du schéma de la figure 1.

Ces coefficients Cij, C'ij représenteront les valeurs de capacités (commutées ou non) du filtre à capacités commutées simulant le filtre de la figure 1.

Dans la réalisation du filtre, — V1, — i2, + V2, + i3, — V3, — i4, + V4, + i5 représenteront les tensions de sortie L, M, N, P, Q, R, S, T de huit amplificateurs opérationnels A1, A2 ... A8. Les capacités de valeur Cij et C'ij sont connectées entre l'entrée de l'amplificateur d'indice i et la sortie de l'amplificateur d'indice j.

E représente la tension à l'entrée du filtre à capacités commutées et est pris égal à — U dans la simulation.

La synthèse du filtre peut alors se faire essentiellement à partir de l'équation matricielle de la figure 3.

Les termes en Cij $(1 - z^{-1})$ représentent une capacité non commutée de valeur Cij entre l'entrée de l'amplificateur Ai et la sortie de l'amplificateur Aj.

Les termes en Cij représentent une capacité commutée non inverseuse, sans introduction de retard.

Les termes en — $Cijz^{-1}$ représentent une capacité commutée inverseuse, avec introduction de retard.

Les termes en $Cijz^{-1}$ s'il y en avait, représenteraient une capacité commutée non inverseuse, avec introduction d'un retard d'une période d'horloge.

Ces différents types de capacités sont représentés à la figure 4 lignes a à d respectivement, avec les commutateurs qui permettent d'établir les retards et inversions de signes nécessaires, et les deux phases de commande de ces commutateurs.

Pour la simplification de la représentation du schéma global du filtre réalisé, on ne représentera pas le détail des commutateurs, d'autant plus que si plusieurs capacités sont connectées à un même point, il est possible de supprimer certains commutateurs redondants.

On représentera simplement d'une part des capacités non commutées Cij, et d'autre part des blocs de liaison correspondant chacun à une capacité commutée.

La référence d'un bloc sera ij pour un bloc qui relie la sortie de l'amplificateur Aj à l'entrée de l'amplificateur Ai. La fonction de transfert introduite par ce bloc, c'est à dire le coefficient de l'équation matricielle à la ligne i et la colonne j, est inscrite à l'intérieur du bloc ij.

Enfin l'entrée de signal du filtre est reliée à l'entrée du premier amplificateur A1 par un bloc 10 de fonction de transfert $(1 + z^{-1})/2$ qui peut

d'ailleurs être constitué par exemple par une capacité non commutée de valeur 1/2 (fonction de transfert $(1 - z^{-1})/2$) en parallèle avec une capacité commutée non inverseuse avec retard, de valeur 1 (de fonction de transfert $z^{-1}$).

La figure 5 représente le schéma de filtre qui se déduit directement, à partir des explications qui précèdent, de l'équation matricielle de la figure 3.

L'inconvénient essentiel de ce schéma, dû à la présence du terme négatif $-C14$ (ligne 1, colonne 4 de l'équation matricielle), est l'obligation d'introduire un amplificateur inverseur AO sans lequel on ne sait pas faire une capacité commutée inverseuse sans retard.

La présente invention parvient à une solution efficace pour éliminer cet amplificateur, moyennant l'introduction d'une capacité de liaison directe supplémentaire (ici entre l'entrée du premier amplificateur A1 et la sortie du cinquième), et en modifiant les valeurs de certaines capacités commutées ou non commutées du schéma. La valeur de la capacité supplémentaire pourra être égale à celle de la capacité connectée entre l'entrée du troisième amplificateur et la sortie du cinquième.

Plus précisément, le schéma modifié est représenté à la figure 6.

Il résulte de la modification suivante de l'équation matricielle de la figure 3 :

La première ligne est multipliée par C34/C14 et est remplacée par la somme de cette première ligne affectée de ce coefficient multiplicatif et de la troisième ligne.

Les autres lignes restant inchangées, on a repris ci-dessous les nouveaux coefficients de la première ligne de l'équation :

Colonne 1 :
$C'11\ C34/C14 + (C11\ C34/C14 + C31)\ (1 - z^{-1})$

Colonne 2 : $C12\ C34/C14 + C32$

Colonne 3 : $(C13\ C34/C14 + C33)\ (1 - z^{-1})$

Colonne 4 : $-C14\ C34/C14 + C34 = 0$

Colonne 5 : $C35\ (1 - z^{-1})$

Colonne 6 : $C16\ C34/C14$

Colonne 7 : 0

Colonne 8 : 0.

Enfin, la colonne de droite de l'équation matricielle qui ne comportait qu'un terme $(1 + z^{-1})/2$, comporte maintenant un terme $(1 + z^{-1})\ C34/2C14$.

Par rapport au schéma de la figure 5, les modifications sont les suivantes :

d'abord et surtout suppression du bloc 14 et de l'amplificateur inverseur A0 ;

ensuite introduction d'une capacité non commutée C'15 de valeur égale à C35 entre la sortie de l'amplificateur A1 et la sortie de l'amplificateur A5 ;

changement de valeur de la capacité commutée du bloc 11 qui devient K'11 = C'11 C34/C14 ;

changement de valeur de la capacité non commutée C11 qui devient C"11 = (C11 C34/C14 + C31) ;

changement de valeur de la capacité du bloc 12 qui devient C'12 = C12 C34/C14 + C32

changement de valeur de la capacité non commutée C13 qui devient C'13 = C13 C34/C14 + C33 ;

changement de valeur de la capacité du bloc 16, qui devient C'16 = C16 C34/C14 ;

changement de valeur de la capacité non commutée et de la capacité commutée du bloc d'entrée 10, les nouvelles valeurs étant multipliées par C34/C14 par rapport aux anciennes.

Le schéma ainsi décrit constitue bien un filtre passe-bande sans nécessiter un nombre d'amplificateurs supérieur à l'ordre de la fonction passe-bande réalisée.

**Revendications**

1. Filtre à capacités commutées simulant un filtre à inductances et capacités, comprenant plusieurs amplificateurs opérationnels (A1, A2, etc.), l'entrée de chacun étant reliée à la sortie d'un ou plusieurs autres ou éventuellement du même par des capacités commutées ou non commutées, caractérisé en ce que les liaisons entre amplificateurs opérationnels pour réaliser une caractéristique passe-bande comprennent les liaisons suivantes :

une capacité non commutée (C"11, C88) en parallèle avec une capacité commutée (11, 88) entre la sortie et l'entrée du premier amplificateur opérationnel (A1) ainsi que du dernier (A8) et une capacité non commutée respective (C22 à C77) en parallèle entre la sortie et l'entrée de chacun des amplificateurs intermédiaires (A2 à A7) ;

une capacité commutée (12) sans retard entre l'entrée du premier et la sortie du second amplificateur, une autre (32) entre l'entrée du troisième et la sortie du second, et encore une autre entre l'entrée du troisième et la sortie du quatrième (34) ;

une capacite commutée inverseuse avec retard (21) entre l'entrée du deuxième amplificateur opérationnel et la sortie du premier, et une autre (23) entre cette même entrée et la sortie du troisième amplificateur ;

une capacité non commutée (C'13) entre l'entrée du premier amplificateur et la sortie du. troisième, une autre (C'15) entre cette même entrée et la sortie du cinquième, une autre (C31) entre l'entrée du troisième et la sortie du premier amplificateur, et enfin une autre (C35) entre cette même entrée du troisième et la sortie du cinquième.

2. Filtre selon la revendication 1, caractérisé en ce qu'aucune capacité, directe ou commutée, n'est prévue entre l'entrée du premier et la sortie du quatrième amplificateur.

3. Filtre selon la revendication 2, caractérisé en ce que la valeur de la capacité non commutée entre l'entrée du premier amplificateur et la sortie du cinquième a une valeur égale à celle qui est connectée entre l'entrée du troisième et la sortie du cinquième amplificateur.

**Claims**

1. Switched capacities filter simulating a filter with inductances and capacities, comprising a plurality of operational amplifiers (A1, A2, etc.), the input of each being connected to the output of one or a plurality of others or eventually of the same through switched or unswitched capacities, characterized in that the connections between operational amplifiers, in order to obtain a pass band characteristic, comprise the following connections :

an unswitched capacity (C"11, C88) in parallel with a switched capacity (11, 88) between the output and the input of the first (A1) and the last (A8) operational amplifiers and an unswitched respective capacity (C22 to C77) in parallel between the output and the input of each of the intermediate amplifiers (A2 to A7) ;

a switched capacity (12) without delay between the input of the first and the output of the second amplifier, another one (32) between the input of the third and the output of the second and still another one between the input of the third and the output of the fourth (34) ;

an inverting switched capacity with delay (21) between the input of the second operational amplifier and the output of the first, and another one (23) between this same input and the output of the third amplifier ;

an unswitched capacity (C'13) between the input of the first amplifier and the output of the third, another one (C'15) between this same input and the output of the fifth, a further one (C31) between the input of the third and the output of the first amplifier, and finally another one (C35) between this same input of the third and the output of the fifth.

2. Filter according to claim 1, characterized in that no capacity, direct or switched, is provided between the input of the first and the output of the fourth amplifier.

3. Filter according to claim 2, characterized in that the value of the unswitched capacity between the input of the first amplifier and the output of the fifth has a value equal to that which is connected between the input of the third and the output of the fifth amplifier.

**Patentansprüche**

1. Filter mit geschalteten Kapazitäten, durch welches ein Filter mit Induktivitäten und Kapazitäten simuliert wird, mit mehreren Operationsverstärkern (A1, A2, usw.), wobei der Eingang jedes von ihnen mit dem Ausgang eines oder mehrerer anderer oder gegebenenfalls desselben über geschaltete oder ungeschaltete Kapazitäten verbunden ist, dadurch gekennzeichnet, daß die Verbindungen zwischen Operationsverstärkern zur Verwirklichung einer Bandpaßcharakteristik folgende Verbindungen umfassen :

eine ungeschaltete Kapazität (C"11, C88) parallel mit einer geschalteten Kapazität (11, 88) zwischen dem Ausgang und dem Eingang des ersten (A1) sowie des letzten (A8) Operationsverstärkers und eine jeweils ungeschaltete Kapazität (C22 bis C77) parallel zwischen dem Ausgang und dem Eingang jedes zwischengeordneten Verstärkers (A2 bis A7) ;

eine verzögerungsfrei geschaltete Kapazität (12) zwischen dem Eingang des ersten und dem Ausgang des zweiten Verstärkers, eine weitere (32) zwischen dem Eingang des dritten und dem Ausgang des zweiten sowie eine weitere zwischen dem Eingang des dritten und dem Ausgang des vierten (34) ;

eine geschaltete invertierende und verzögerungsbehaftete Kapazität (21) zwischen dem Eingang des zweiten Operationsverstärkers und dem Ausgang des ersten sowie eine weitere (23) zwischen diesem selben Eingang und dem Ausgang des dritten Verstärkers ;

eine ungeschaltete Kapazität (C'13) zwischen dem Eingang des ersten Verstärkers und dem Ausgang des dritten, eine weitere (C'15) zwischen diesem selben Eingang und dem Ausgang des fünften, eine weitere (C31) zwischen dem Eingang des dritten und dem Ausgang des ersten Verstärkers sowie eine weitere (C35) zwischen diesem selben Eingang des dritten und dem Ausgang des fünften.

2. Filter nach Anspruch 1, dadurch gekennzeichnet, daß keinerlei Kapazität, direkt oder geschaltet, zwischen dem Eingang des ersten und dem Ausgang des vierten Verstärkers vorgesehen ist.

3. Filter nach Anspruch 2, dadurch gekennzeichnet, daß der Wert der ungeschalteten Kapazität zwischen dem Eingang des ersten Verstärkers und dem Ausgang des fünften einen Wert aufweist, der gleich demjenigen ist, welcher zwischen den Eingang des dritten und den Ausgang des fünften Verstärkers geschaltet ist.

Fig.1

a) $\boxed{Cij(1-z^{-1})}$ $\equiv$ $\dashv\vdash Cij$

b) $\boxed{Cij}$ $\equiv$ K1 K2

c) $\boxed{-Cij\,z^{-1}}$ $\equiv$ K4 K5

d) $\boxed{Cij\,z^{-1}}$ $\equiv$ K3

Fig.4

0 130 873

$$
\begin{bmatrix}
-1-(C1+C2)\Delta & -(1+L2/L1) & C2\Delta & -L3/L1 & 0 & -L4/L1 & 0 & 0 \\
1 & -L2\Delta & -1 & 0 & 0 & 0 & 0 & 0 \\
C2\Delta & 1 & -(C2+C3)\Delta & -1 & C3\Delta & 0 & 0 & 0 \\
0 & 0 & 1 & -L3\Delta & -1 & 0 & 0 & 0 \\
0 & 0 & C3\Delta & 1 & -(C3+C4+C5)\Delta & -1 & C5\Delta & 0 \\
0 & 0 & 0 & 0 & 1 & -L4\Delta & 0 & 0 \\
0 & 0 & 0 & 0 & C5\Delta & 0 & -C5\Delta & -1 \\
0 & 0 & 0 & 0 & 0 & 0 & 1 & -(1+L5\Delta)
\end{bmatrix}
\begin{bmatrix}
V1 \\ i2 \\ V2 \\ i3 \\ V3 \\ i4 \\ V4 \\ i5
\end{bmatrix}
+
\begin{bmatrix}
1 \\ 0 \\ 0 \\ 0 \\ 0 \\ 0 \\ 0 \\ 0
\end{bmatrix}
U = 0
$$

Fig.2

0 130 873

$$\begin{bmatrix}
C'_{11}+C_{11}(1-z^{-1}) & C_{12} & C_{13}(1-z^{-1}) & -C_{14} & 0 & C_{16} & 0 & 0 \\
-C_{21}z^{-1} & C_{22}(1-z^{-1}) & -C_{23}z^{-1} & 0 & 0 & 0 & 0 & 0 \\
C_{31}(1-z^{-1}) & C_{32} & C_{33}(1-z^{-1}) & C_{34} & C_{35}(1-z^{-1}) & 0 & 0 & 0 \\
0 & 0 & -C_{43}z^{-1} & C_{44}(1-z^{-1}) & -C_{45}z^{-1} & 0 & 0 & 0 \\
0 & 0 & C_{53}(1-z^{-1}) & C_{54} & C_{55}(1-z^{-1}) & C_{56} & C_{57}(1-z^{-1}) & 0 \\
0 & 0 & 0 & 0 & -C_{65}z^{-1} & C_{66}(1-z^{-1}) & 0 & 0 \\
0 & 0 & 0 & 0 & C_{75}(1-z^{-1}) & 0 & C_{77}(1-z^{-1}) & 2C_{78} \\
0 & 0 & 0 & 0 & 0 & 0 & -2C_{87}z^{-1} & C'_{88}+C_{88}(1-z^{-1})
\end{bmatrix}
\begin{bmatrix}
-V_1 \\ -i_2 \\ V_2 \\ i_3 \\ -V_3 \\ -i_4 \\ V_4 \\ i_5
\end{bmatrix}
+
\begin{bmatrix}
\frac{1+z^{-1}}{2}E \\ 0 \\ 0 \\ 0 \\ 0 \\ 0 \\ 0 \\ 0
\end{bmatrix}
= 0$$

Fig.3

0 130 873

Fig.5

0 130 873

Fig.6